# EUROPEAN PATENT APPLICATION

(11) **EP 4 819 795 A1**
(43) Date of publication of application: **07.10.2026**
(21) Application number: 25305475.3
(22) Date of filing: 31.03.2025
(51) Int. Cl.: H10D 89/60, H02H 9/04

(54) **A SEMICONDUCTOR DEVICE**

(71) Applicant: NXP USA, Inc., Austin TX 78735 (US)
(72) Inventor: LAINE, Jean-Philippe, 31023 Toulouse (FR); JRADI, Khalil, 31023 Toulouse (FR)
(74) Representative: Schmütz, Christian Klaus Johannes

(57) **Abstract**

A semiconductor device comprising: a substrate; an epitaxial layer arranged on the surface of the substrate, the epitaxial layer comprising: a first p-doped region, a second p-doped region and a third p-doped region arranged laterally with the second p-doped region positioned between; a first n-doped region positioned between the first p-doped region and the second p-doped region; a second n-doped region positioned between the second p-doped region and the third p-doped region; a metal contact layer arranged above the epitaxial layer, the metal contact layer comprising: a signal connection comprising a first metal contact and a second metal contact; and a ground metal contact, wherein the first metal contact is connected to the first p-doped region, the ground metal contact is connected to the second p-doped region and the second metal contact is connected to the third p-doped region.

## Description

### Field

The present disclosure relates to a semiconductor device.

### Summary

According to a first aspect of the present disclosure there is provided a semiconductor device comprising:
a substrate;
an epitaxial layer arranged on the surface of the substrate, the epitaxial layer comprising:
   a first p-doped region, a second p-doped region and a third p-doped region arranged laterally with the second p-doped region positioned between the first p-doped region and the third p-doped region;
   a first n-doped region positioned between the first p-doped region and the second p-doped region;
   a second n-doped region positioned between the second p-doped region and the third p-doped region;
a metal contact layer arranged above the epitaxial layer, the metal contact layer comprising:
   a signal connection comprising a first metal contact and a second metal contact; and
   a ground metal contact,
wherein the first metal contact is connected to the first p-doped region, the ground metal contact is connected to the second p-doped region and the second metal contact is connected to the third p-doped region.

In one or more embodiments the second p-doped region positioned may be spaced apart from the first p-doped region and the third p-doped region.

In one or more embodiments, the first metal contact is separate from the first metal contact.

In one or more embodiments, the first p-doped region, the second p-doped region and the first n-doped region may form a first bidirectional PNP transistor between the first metal contact and the ground metal contact. The second p-doped region, the third p-doped region and the second n-doped region may form a second bidirectional PNP transistor between the second metal contact and the ground metal contact.

In one or more embodiments, the first n-doped region and the second n-doped region may form a common base terminal of the first and second bidirectional PNP transistors.

In one or more embodiments, the p-doped regions and the n-doped regions comprise elongate regions extending perpendicular to the lateral direction and parallel to the surface of the substrate. A finger of the first metal contact may be connected to the first p-doped region. A finger of the ground contact may be connected to the second p-doped region. A finger of the second metal contact may be connected to the third p-doped region.

In one or more embodiments, the epitaxial layer may comprise:
a fourth p-doped region arranged laterally with the first, second and third p-doped regions; and
a third n-doped region positioned between the third p-doped region and the fourth p-doped region,
wherein the ground metal contact is connected to the fourth p-doped region.

In one or more embodiments, the third p-doped region, the fourth p-doped region and the third n-doped region may form a third bidirectional PNP transistor between the second metal contact and the ground metal contact.

In one or more embodiments, the first to fourth p-doped regions, the first to third n-doped regions and the metal contact layer may comprise a unit cell of the semiconductor device that is repeated an integer number of times in the lateral direction.

According to a second aspect of the present disclosure, there is provided a semiconductor device comprising:
a substrate;
an electrostatic discharge, ESD, protection circuit comprising an epitaxial layer arranged on the substrate and having a plurality of laterally arranged PNP cells; and
a metal contact layer comprising:
   a signal connection comprising a first metal contact and a second metal contact; and
   a ground metal contact, wherein the first metal contact, the second metal contact and the ground metal contact each comprise a plurality of electrically connected fingers,
wherein each finger of the ground metal contact is positioned between a finger of the first metal contact and a finger of the second metal contact.

In one or more embodiments, each finger of the ground metal contact may be positioned directly or immediately between a finger of the first metal contact and a finger of the second metal contact.

In one or more embodiments, the PNP cells may form:
a first plurality of bidirectional PNP transistors coupled between the first metal contact and the ground metal contact;
a second plurality of bidirectional PNP transistors coupled between the second metal contact and the ground metal contact,
wherein the first plurality of bidirectional PNP transistors and the second plurality of bidirectional PNP transistors are effectively shared to form a third plurality of bidirectional PNP transistors coupled between the first metal contact and the second metal contact.

In one or more embodiments, the substrate may comprise a n-doped buried layer extending laterally at a surface of the substrate.

In one or more embodiments, the signal connection may be a differential signal connection. The first metal contact may comprise a first differential metal contact. The second metal contact may comprise a second differential metal contact.

According to a third aspect of the present disclosure there is provided a CAN device comprising any semiconductor device disclosed herein.

In one or more embodiments, the first metal contact may comprise a CAN-H contact for coupling to a CAN bus and the second metal contact may comprise a CAN-L contact for coupling to the CAN bus.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example semiconductor device comprising a multi-pin signal connection;
Figure 2 illustrates transmission line pulse (TLP) measurements of the semiconductor device of Figure 1;
Figure 3 illustrates a second example semiconductor device comprising a signal connection with ESD protection between each IO pin and the ground pin;
Figure 4 illustrates a schematic top level contact view and a schematic cross-sectional view of the semiconductor device of Figure 3;
Figure 5 illustrates TLP measurements of the semiconductor device of Figures 3 and 4;
Figure 6 illustrates a semiconductor device according to an embodiment of the present disclosure;
Figure 7 illustrates a schematic top level contact view and a schematic cross-sectional view of the semiconductor device of Figure 6; and
Figure 8 illustrates TLP measurements of the semiconductor device of Figures 6 and 7.

### Detailed Description

Semiconductor devices including integrated circuits with differential signal I/O connections can require robustness against electrostatic discharge. For example, controller area network (CAN) bus applications or multi-channel pins applications require robustness for ESD GUN stress.

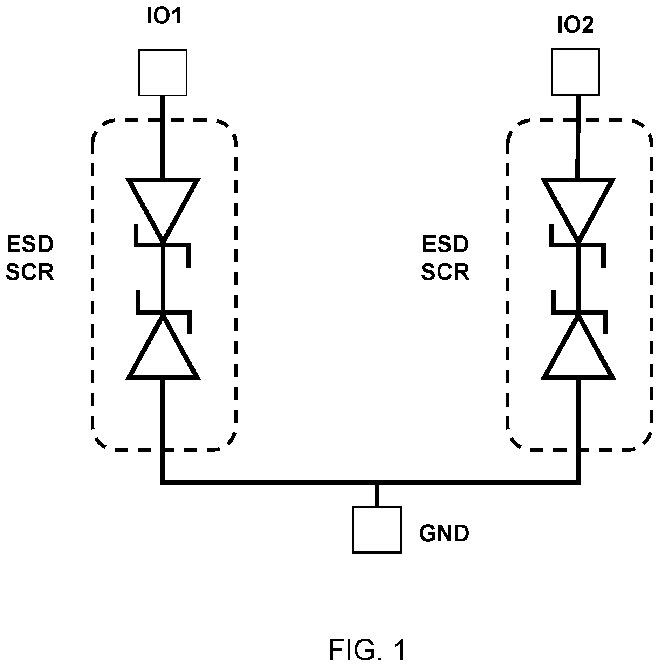

Figure 1 illustrates an example semiconductor device comprising a signal connection in the form of first and second bus pins, *IO1* and *IO2.* The first and second bus pins, IO1, IO2 are examples of first and second metal contacts. The semiconductor device comprises an ESD protection device including an epitaxial layer structure with p-doped and n-doped regions to form: (i) a silicon controlled rectifier (SCR) between the first bus pin IO1, and a ground pin, GND; and (ii) a silicon controlled rectifier (SCR) between the second bus pin, IO2, and the ground pin, GND.

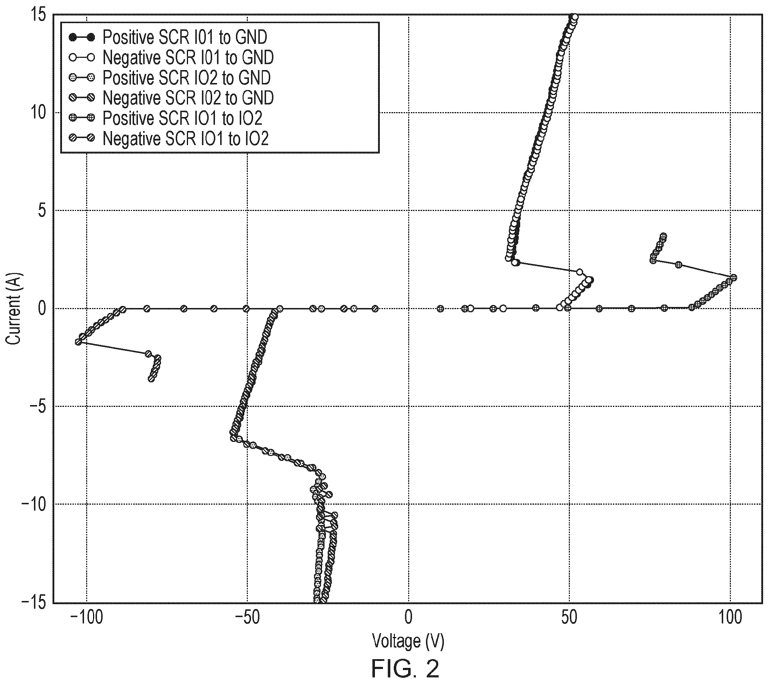

Figure 2 illustrates transmission line pulse (TLP) measurements of the semiconductor device of Figure 1. A voltage drop of less than ± 50V is observed for ESD tests of the first bus pin, IO1, versus ground and the second bus pin, IO2, versus ground. However, a voltage drop of over ±80V is observed between the first bus pin, IO1, and the second bus pin, IO2.

In other words, the semiconductor device of Figure 1 provides robust ESD protection between each of the IO bus pins and the ground pin and the semiconductor device can pass the typical ESD requirements. However, the semiconductor device of Figure 1 may fail to meet some more stringent ESD requirements.

To enhance the semiconductor device of Figure 1, additional ESD protection is required between the IO bus pins (between the first bus pin, IO1, and the second bus pin, IO2). However, providing such protection typically requires additional die area.

The present disclosure can provide a semiconductor device with ESD protection for a multi-pin signal connection that can meet full ESD requirements without requiring an increase in die area. The semiconductor device comprises ESD protection in the form of an epitaxial layer with PNP cells and an arrangement of the metal contact layer to share the HV PNP cells between each IO pin and the ground pin and also between the IO pins.

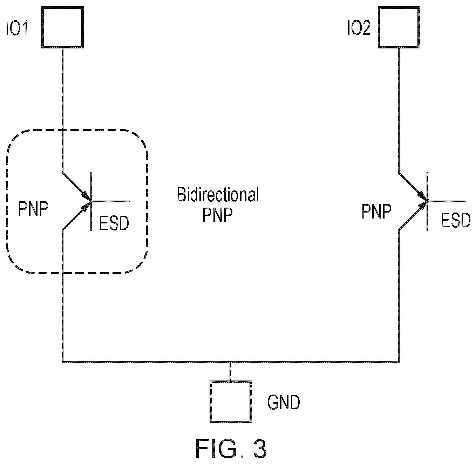

Figure 3 illustrates a second example semiconductor device comprising a multi-pin signal connection (IO1, IO2) with ESD protection between each IO pin and the ground pin. The example is similar to the semiconductor device of Figure 1 other than the SCR has been replaced by a PNP transistor using floating base.

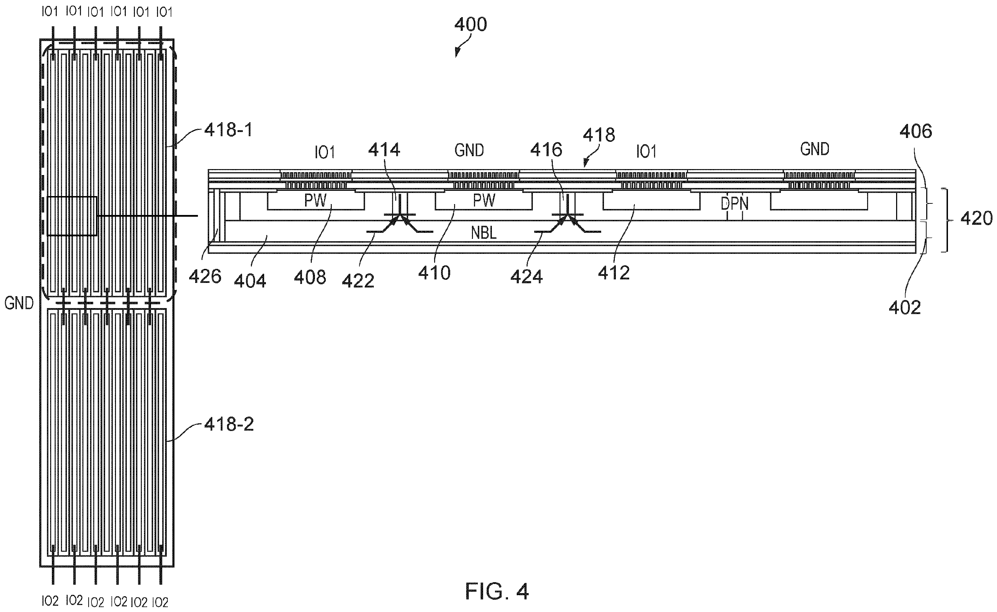

Figure 4 illustrates a schematic top level contact view and a schematic cross-sectional view of the semiconductor device of Figure 3.

As seen in the top view, a first half 418-1 of a metal contact layer 418 comprises alternating fingers of a first bus pin connection, IO1, (a first metal contact) and a ground connection, GND, (a ground metal contact). A second half 418-2 of the metal contact layer 418 comprises alternating fingers of a second bus pin connection, IO2, (a second metal contact) and the ground connection, GND. As described here, a finger of a metal contact is an elongate section (i.e. longer in a length axis than a width axis) of a metal contact that is electrically connected with other fingers of the same metal contact.

The cross-sectional view illustrates the semiconductor structure underlying the first half 418-1 of the metal contact layer 418.

The semiconductor device comprises a substrate 402. The substrate 402 may comprise a buried oxide layer underlying the n-buried layer (NBL) 404 and laterally separated by a deep trench isolation (DTI) 426. The n-buried layer (NBL) 404 is manufactured in the substrate 402, for example by masking and ion implantation. The NBL 404 comprises a relatively large amount of n-type material. The NBL 404 forms a layer within the substrate 402 that extends laterally at a surface of the substrate 402 and vertically from the surface of the substrate 402 to a NBL depth. The substrate 402 may include a buried oxide layer underlying the NBL 404.

The semiconductor device 400 further comprises an epitaxial layer 406 manufactured on the surface of the substrate 402. The epitaxial layer 406 comprises: a first p-doped region 408; a second p-doped region 410; and a third p-doped region 412 with the second p-doped region 410 positioned between (and space apart from both of) the first p-doped region 408 and the third p-doped region 412. In this example, the first, second and third p-doped regions 408, 410, 412 comprise p-well regions (labelled PW). The first, second and third p-doped regions 408, 410, 412 may form elongate regions (i.e. longer in a length axis than a width axis) that extend perpendicular to the lateral direction and parallel to the surface of the substrate 402 (i.e. in and out of the page). These p-doped regions can be similar or different.

The epitaxial layer 406 also comprises a: first n-doped region 414 positioned between the first and second p-doped regions 408, 410; and a second n-doped region 416 positioned between the second and third p-doped regions 410, 412. The first and second n-doped region 414, 416 are deep n-doped regions (labelled DPN) and extend through the epitaxial layer 406 from a top surface of the epitaxial layer 406 to the NBL 404. The first and second n-doped regions 414, 416, may form elongate regions that extend perpendicular to the lateral direction and parallel to the surface of the substrate 402 (i.e. in and out of the page).

The substrate 402 and the epitaxial layer 406 can form a semiconductor substrate 420 for a metal contact layer 418 of an integrated circuit. In particular, the semiconductor substrate 420 can provide ESD protection for a signal connection of an integrated circuit. The semiconductor device 400 comprises the metal contact layer 418 positioned above the semiconductor substrate. The metal contact layer 418 comprises a plurality of metal contacts coupled to the p-doped regions 408, 410, 412.

In the first half 418-1 of the metal contact layer 418, the metal contact layer 418 comprises alternating fingers of a first metal contact, IO1, and a ground metal contact, *GND.* For example: the first p-doped region 408 is connected to a first finger of the first metal contact, IO1; the second p-doped region 410 is connected to a first finger of the ground contact, *GND;* the third p-doped region 412 is connected to a second finger of the first metal contact, *IO1*; and so on. In this way, the first p-doped region 408, the second p-doped region 410 and the first n-doped region 414 form a first bidirectional PNP bipolar transistor 422, with the first p-doped region 408 forming the bidirectional emitter/collector, the second p-doped region 410 forming respectively the bidirectional collector/emitter and the n-doped regions 414 and 404 forming the base. In a similar manner, the second p-doped region 410, the third p-doped region 412 and the second n-doped region 416 form a second parallel bidirectional PNP bipolar transistor 424. In this example, the alternating IO1 and GND metal contacts effectively form 10 bidirectional PNP bipolar transistors between the first metal contact, IO1 and the ground metal contact, GND.

The second half 418-2 of the metal contact layer 418 comprises a similar cross-section to the first half 418-1 with the only difference being the first metal contact, IO1, is replaced by the second metal contact IO2. In other words, the second half 418-2 comprises alternating fingers of the second metal contact, *102,* and the ground metal contact, *GND.* In this way, the alternating IO2 and GND metal contacts effectively form 10 bidirectional PNP bipolar transistors between the second metal contact, IO2, and the ground metal contact, GND.

In this way, the semiconductor device of Figures 3 and 4 is similar to the semiconductor device of Figure 1 in that it comprises ESD protection between the ground contact, GND, and each metal contact, IO1, IO2, but not between the metal contacts, IO1, IO2 themselves.

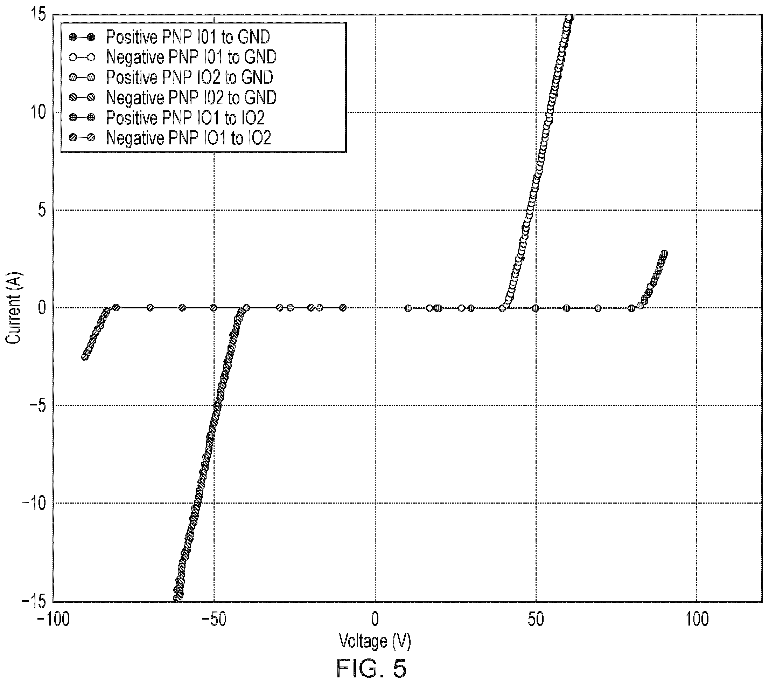

Figure 5 illustrates the TLP measurements of the semiconductor device of Figures 3 and 4. A voltage drop of less than ± 50V is observed for ESD tests of the IO1 pin versus ground and the IO2 pin versus ground. However, a voltage drop of over ±80V is still observed between the IO1 pin and the IO2 pin.

In other words, the semiconductor device of Figures 3 and 4 is similar to that of Figure 1 in that it provides robust ESD protection between each of the IO pins and the ground pin and the semiconductor device can pass the typical ESD requirements. However, the semiconductor device still fails to meet the more robust ESD requirements.

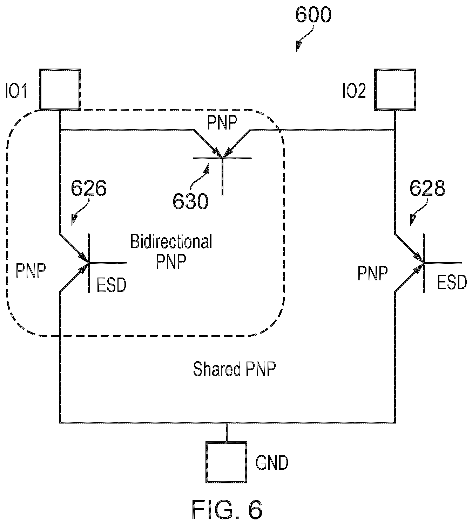

Figure 6 illustrates a semiconductor device 600 according to an embodiment of the present disclosure. In this example, the semiconductor device 600 comprises ESD protection in the form of an epitaxial layer with PNP cells / transistors and a connection arrangement of the metal contact layer to share the PNP cells between each metal contact, IO1, IO2 and the ground metal contact and also between the metal contacts IO1, IO2.

As a result, the semiconductor device comprises a ESD circuit comprising: a first plurality of bidirectional PNP transistors 626 coupled between the first metal contact, IO1, and the ground metal contact, GND; and a second plurality of bidirectional PNP transistors 628 coupled between the second metal contact, IO2 and the ground metal contact, GND. The metal contact layer can arranged to position fingers of the ground metal contact, GND, between a finger of the first metal contact IO1 and a finger of the second metal contact, IO2. For example, each ground metal contact, GND, may be positioned between a finger of the first metal contact IO1 and a finger of the second metal contact, IO2. As a result, the first plurality of bidirectional PNP transistors 626 and the second plurality of bidirectional transistors 628 are effectively shared to provide a third plurality of bidirectional transistors 630 between the first metal contact, IO1, and the second metal contact, IO2.

The first metal contact, IO1, and the second metal contact, IO2, are an example of a multi-pin IO connection. The first and second metal contacts, IO1, IO2, may form a differential signal connection.

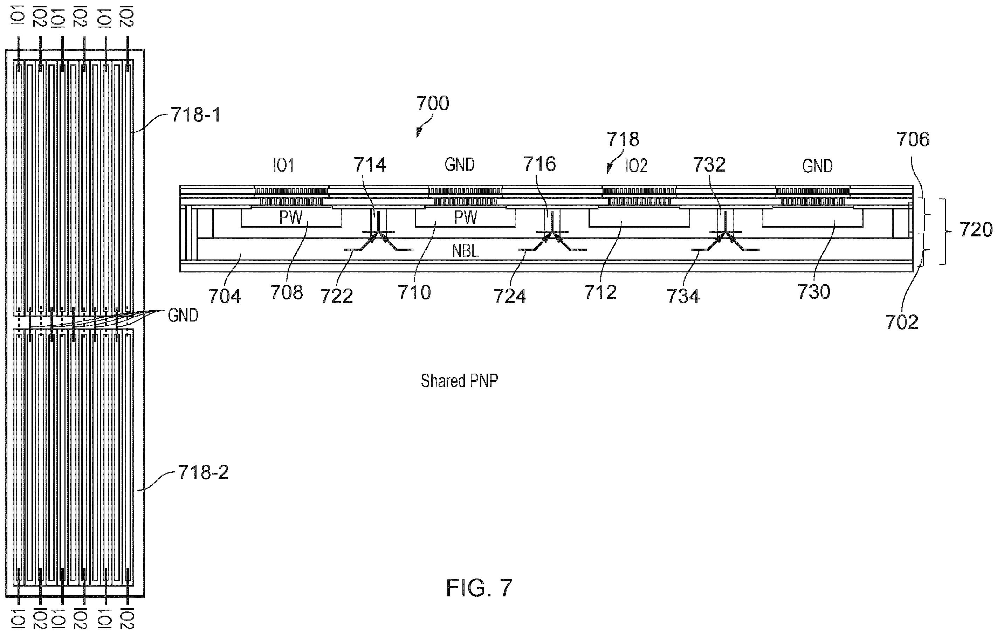

Figures 7 illustrates a schematic top level contact view and a schematic cross-sectional view of the semiconductor device of Figure 6. Features of Figure 7 that also appear in Figure 4 have been given corresponding numbering in the 700 series and will not necessarily be described again.

As seen in the top view, both the first half 718-1 and the second half 718-2 of a metal contact layer 718 comprises fingers of the ground metal contact, GND, positioned between fingers of the first metal contact, IO1, and the second metal contact, IO2. Specifically, each finger of the ground metal contact, GND, is positioned between a finger of the first metal contact, IO1, and a finger of the second metal contact, IO2.

The cross-sectional view illustrates the semiconductor structure underlying the first half 718-1 of the metal contact layer 718 (which is substantially identical to the second half 718-2).

The semiconductor device comprises a substrate 702. The substrate 702 may comprise a buried oxide layer underlying the n-buried layer (NBL) 404 and laterally separated by the deep trench isolation (DTI) 426. The n-buried layer (NBL) 704 is manufactured in the substrate 702, for example by masking and ion implantation. The NBL 704 may comprise a relatively large amount of n-type material. The NBL 704 forms a layer within the substrate 702 that extends laterally at a surface of the substrate 702 and vertically from the surface of the substrate 702 to a NBL depth. The substrate 702 may include a buried oxide layer underlying the NBL 704.

The semiconductor device 700 further comprises an epitaxial layer 706 manufactured on the surface of the substrate 702. The epitaxial layer 706 comprises: a first p-doped region 708; a second p-doped region 710; and a third p-doped region 712 with the second p-doped region 710 positioned between (and space apart from both of) the first p-doped region 708 and the third p-doped region 712. In this example, the first, second and third p-doped regions 708, 710, 712 comprise p-well regions (labelled PW). The first, second and third (and fourth) p-doped regions 708, 710, 712, (730) may form elongate regions that extend perpendicular to the lateral direction and parallel to the surface of the substrate 702 (i.e. in and out of the page). The p-doped regions may be the same or different to each other (e.g. same or different dimensions and/or doping).

The epitaxial layer 706 also comprises a: first n-doped region 714 positioned between the first and second p-doped regions 708, 710; and a second n-doped region 716 positioned between the second and third p-doped regions 710, 712. The first and second n-doped region 714, 716 are deep n-doped regions (labelled DPN) and extend through the epitaxial layer 706 from a top surface of the epitaxial layer 706 to the NBL 704. The first and second (and third) n-doped regions 714, 716, (732), may form elongate regions that extend perpendicular to the lateral direction and parallel to the surface of the substrate 702 (i.e. in and out of the page).

The substrate 702 and the epitaxial layer 706 can form a semiconductor substrate 720 for a metal contact layer 718 of an integrated circuit. In particular, the semiconductor substrate 720 can provide ESD protection for a signal connection, IO1, IO2 of an integrated circuit. The semiconductor device 700 comprises the metal contact layer 718 positioned above the semiconductor substrate 720. The metal contact layer 718 comprises a plurality of metal contacts IO1, IO2, GND, coupled to the p-doped regions 708, 710, 712.

The metal contact layer 718 comprises fingers of the ground metal contact, GND, positioned immediately adjacent (i.e. directly adjacent) to a finger of the first metal contact, *IO1*, on a first side of the ground contact, and positioned immediately adjacent to a finger of the second metal contact, *IO2* on a second side of the ground metal contact (opposite the first side). For example: the first p-doped region 708 is connected to a first finger of the first metal contact, IO1; the second p-doped region 710 is connected to a first finger of the ground contact, GND; and the third p-doped region 712 is connected to a first finger of the second metal contact, IO2. In this way, the first p-doped region 708, the second p-doped region 710 and the first n-doped region 714 form a first bidirectional PNP bipolar transistor 722 between the IO1 and GND, with the first p-doped region 708 forming the bidirectional collector/emitter, the second p-doped region 710 forming the respective bidirectional emitter/collector and the first n-doped region 714 (and NBL 704) forming the base. In a similar manner, the second p-doped region 710, the third p-doped region 712 and the second n-doped region 716 form a second bidirectional PNP bipolar transistor 724 between GND and IO2. The arrangement of the ground metal contact between differing first and second metal contacts results in the first bidirectional PNP bipolar transistor 722 and the second bidirectional PNP transistor 724 forming an effective bidirectional PNP transistor between the first and second metal contacts, IO1, IO2, as depicted in Figure 6. The first and second bidirectional PNP transistors 722, 724, may have a common base (the first and second n-doped regions 714, 716 and NBL 704 are at same potential) resulting in the effective PNP transistor between the first and second metal contacts IO1, IO2.

In this example, the epitaxial layer 706 comprises a fourth p-doped region 730 and a third n-doped region 732 positioned between the third p-doped region 712 and the fourth p-doped region 730. A second finger of the ground metal contact, GND, is connected to the fourth p-doped region 730 to form a third PNP transistor 734 between the ground metal contact, GND and the second metal contact, IO2. The structure of the first to fourth p-doped regions 708, 710, 712, 730 with the intervening first to n-doped regions 714, 716, 732 and associated metal contact connections, may be considered as a unit cell of the semiconductor device 700. The unit cell may be repeated an integer number of times across the width of the illustrated metal contact area 718. In the illustrated example, this unit cell is repeated twice although the third unit cell does not include the third n-doped region and the fourth p-doped region because the last contact finger is a third finger of the second metal contact, IO2.

In summary, semiconductor device 700 comprises an epitaxial layer comprising a plurality of PNP cells, with each p-region 708, 710, 712, 730 of the PNP cell connected to a finger of one of the metal contacts, IO1, IO2, GND, with each finger of the ground metal contact, GND, positioned immediately between a finger of the first metal contact, IO1 and a finger of the second metal contact, IO2.

The second half 718-2 of the metal contact layer 718 comprises a substantially identical cross-section to the first half 718-1. In this example, each finger of the first metal contact, IO1, in the first half 718-1 is aligned with each finger of the first metal contact, IO1, in the second half 718-2, and the fingers in each half are connected (shown by dashed lines). Similarly, each finger of the second metal contact, IO2, in the first half 718-1 is aligned with each finger of the second metal contact, IO2, in the second half 718-2, and the fingers in each half are connected (shown by dashed lines). As described above, fingers of the ground metal contact, GND, are positioned immediately between a finger of the first metal contact, IO1, and a finger of the second metal contact, IO2. As a result, the fingers of the ground metal contact in the first half 718-1 are aligned with the fingers of the ground metal contact in the second half 718-2 and the fingers in each half are connected (shown by solid lines).

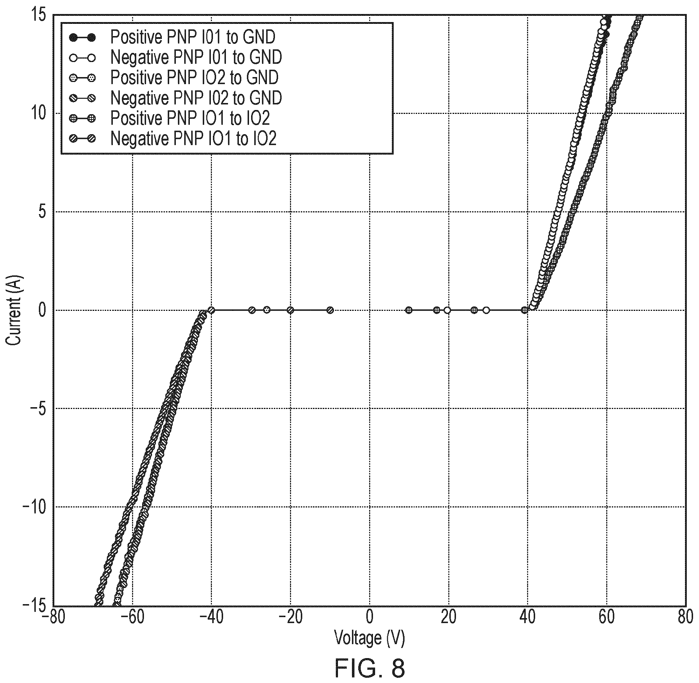

Figure 8, illustrates the TLP measurements of the semiconductor device of Figures 6 and 7. A voltage drop of less than ± 50V is observed for ESD tests of the IO1 pin versus ground and the IO2 pin versus ground. In this example, the effective PNP cell sharing arising from the arrangement of the metal contact layer additionally results in a voltage drop of less than ±50V between the IO1 pin and the IO2 pin.

In other words, the semiconductor device of Figures 6 and 7 provides robust ESD protection between each of the IO pins and the ground pin and between the two IO pins such that the semiconductor device can pass the full ESD requirements. The improved ESD performance is provided without any increase in die area relative to the first and second example semiconductor circuits.

Table 1 illustrates ESD GUN requirement test results on IO1 & IO2 pins for the semiconductor devices of Figures 1, 3/4 and 6/7 respectively. The semiconductor device of Figures 6 & 7 with shared PNP shows a significant improvement in GUN performance relative to the other two circuits. The improvement in ESD GUN performance is a result of the additional protection between the two contacts (IO1 & IO2).

**Table 1: Gun test results**

| **ESD cell** | **Config. IO** | **ESD1 IO2** | **ESD1 IO1** |
|---|---|---|---|
| SCR | Single | ±9kV | ±8kV |
| PNP | Single | ±11kV | ±9kV |
| Shared PNP | Shared | ±12kV | ±13kV |

The disclosed semiconductor devices can protect integrated circuits with multi-pin signal connections from ESD stress using shared HV PNP cells without an increase in die area relative to state of the art approaches.

The semiconductor device may comprise a signal connection with more than two metal contacts, for example the signal connection may comprise multiple pairs of bus pins. The signal connection may comprise a differential signal connection. For example, the semiconductor device may form part of a CAN transceiver and the differential signal connection may comprise CAN bus pins, CAN-H and CAN-L.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A semiconductor device comprising:
a substrate;
an epitaxial layer arranged on the surface of the substrate, the epitaxial layer comprising:
a first p-doped region, a second p-doped region and a third p-doped region arranged laterally with the second p-doped region positioned between the first p-doped region and the third p-doped region;
a first n-doped region positioned between the first p-doped region and the second p-doped region;
a second n-doped region positioned between the second p-doped region and the third p-doped region;
a metal contact layer arranged above the epitaxial layer, the metal contact layer comprising:
a signal connection comprising a first metal contact and a second metal contact; and
a ground metal contact,
wherein the first metal contact is connected to the first p-doped region, the ground metal contact is connected to the second p-doped region and the second metal contact is connected to the third p-doped region.

2. The semiconductor device of claim 1, wherein:
the first p-doped region, the second p-doped region and the first n-doped region form a first bidirectional PNP transistor between the first metal contact and the ground metal contact; and
the second p-doped region, the third p-doped region and the second n-doped region form a second bidirectional PNP transistor between the second metal contact and the ground metal contact.

3. The semiconductor device of claim 2, wherein the first n-doped region and the second n-doped region form a common base terminal of the first and second bidirectional PNP transistors.

4. The semiconductor device of any preceding claim, wherein:
the p-doped regions and the n-doped regions comprise elongate regions extending perpendicular to the lateral direction and parallel to the surface of the substrate;
a finger of the first metal contact is connected to the first p-doped region;
a finger of the ground contact is connected to the second p-doped region; and
a finger of the second metal contact is connected to the third p-doped region.

5. The semiconductor device of any preceding claim, wherein the epitaxial layer comprises:
a fourth p-doped region arranged laterally with the first, second and third p-doped regions; and
a third n-doped region positioned between the third p-doped region and the fourth p-doped region,
wherein the ground metal contact is connected to the fourth p-doped region.

6. The semiconductor device of claim 5, wherein the third p-doped region, the fourth p-doped region and the third n-doped region form a third bidirectional PNP transistor between the second metal contact and the ground metal contact.

7. The semiconductor device of claim 5 or claim 6, wherein the first to fourth p-doped regions, the first to third n-doped regions and the metal contact layer comprise a unit cell of the semiconductor device that is repeated an integer number of times in the lateral direction.

8. A semiconductor device comprising:
a substrate;
an electrostatic discharge, ESD, protection circuit comprising an epitaxial layer arranged on the substrate and having a plurality of laterally arranged PNP cells; and
a metal contact layer comprising:
a signal connection comprising a first metal contact and a second metal contact; and
a ground metal contact, wherein the first metal contact, the second metal contact and the ground metal contact each comprise a plurality of electrically connected fingers,
wherein each finger of the ground metal contact is positioned between a finger of the first metal contact and a finger of the second metal contact.

9. The semiconductor device of claim 8, wherein each finger of the ground metal contact is positioned directly between a finger of the first metal contact and a finger of the second metal contact.

10. The semiconductor device of claim 8 or claim 9, wherein the PNP cells form:
a first plurality of bidirectional PNP transistors coupled between the first metal contact and the ground metal contact;
a second plurality of bidirectional PNP transistors coupled between the second metal contact and the ground metal contact,
wherein the first plurality of bidirectional PNP transistors and the second plurality of bidirectional PNP transistors are effectively shared to form a third plurality of bidirectional PNP transistors coupled between the first metal contact and the second metal contact.

11. The semiconductor device of any preceding claim, wherein the substrate comprises a n-doped buried layer extending laterally at a surface of the substrate.

12. The semiconductor device of any preceding claim, wherein:
the signal connection is a differential signal connection;
the first metal contact comprises a first differential metal contact; and
the second metal contact comprises a second differential metal contact.

13. A CAN device comprising the semiconductor device of any preceding claim.

14. The CAN device of claim 13, wherein the first metal contact comprises a CAN-H contact for coupling to a CAN bus and the second metal contact comprises a CAN-L contact for coupling to the CAN bus.
